# EUROPEAN PATENT SPECIFICATION

(11) **EP 0 400 670 B1**
(45) Date of publication and mention of the grant of the patent: **24.08.1994**
(21) Application number: 90110472.9
(22) Date of filing: 01.06.1990
(51) Int. Cl.: H01L 29/788, H01L 21/336, G11C 17/00

(54) **Semiconductor memory device and method of manufacturing the same**
Halbleiterspeicheranordnung und Verfahren zu ihrer Herstellung
Dispositif de mémoire semi-conducteur et sa méthode de fabrication

(30) Priority: 01.06.1989 JP 137452/89
(43) Date of publication of application: 05.12.1990
(73) Proprietor: KABUSHIKI KAISHA TOSHIBA, Kawasaki-shi, Kanagawa-ken 210 (JP)
(72) Inventor: Noda, Michiaki, Machida-shi, Tokyo-To (JP); Kanebako, Kazunori, Yokohama-shi, Kanagaea-ken (JP); Tanaka, Shinichi, Ota-ku, Tokyo-To (JP)
(74) Representative: Lehn, Werner, Dipl.-Ing.

(56) References cited:
- DE-A- 2 812 049
- US-A- 4 302 766
- US-A- 4 622 656
- PATENT ABSTRACTS OF JAPAN, vol. 5, no. 179 (E-82)[851], 17th November 1981; & JP-A-56 104 473

## Description

### BACKGROUND OF THE INVENTION

This invention relates to a semiconductor memory device and a method of manufacturing the same. In particular, it relates to a semiconductor memory device provided with a control gate on top of a floating gate or a channel that is on a drain side, and a method of manufacturing such a semiconductor memory device.

A conventional flash EEPROM type of semiconductor device has an n-type source and an n-type drain formed in the surface of a p-type semiconductor substrate, and a floating gate is formed in the proximity of the drain on top of an oxide film on a channel between the drain and source. A floating gate and a control gate are formed above an offset portion (F) between the floating gate end and the source end, with an oxide film thereunder. In addition, a p-type impurity region of an impurity concentration greater than that of the substrate is formed uniformly in the channel between the drain and source.

However, this conventional semiconductor memory device has the following problem. In order to improve the memory cell write characteristics of such a semiconductor memory device wherein the impurity concentration of an impurity region formed in a channel is uniform over the entire area from a portion in contact with the drain to a portion in contact with the source, it is preferable to increase the impurity concentration of the impurity region. The electric field can easily focus in this region, the generation probability of electrons injected into the floating gate is increased, and the memory cell write characteristics are improved. However, if the concentration of the impurity in the impurity region is increased, the threshold voltage Vₜₕ of the offset transistor (hereinafter the transistor in the offset portion (F) will be called the offset transistor) also increases, making it difficult for current to flow in the memory cell and hence increasing access times. Conversely, if the concentration of the impurity in the impurity region is reduced, the threshold voltage Vₜₕ of the offset transistor will drop, improving the memory cell's access times but making the memory cell write characteristics worse. Because of these conflicting problems, it is difficult to satisfy demands for both improved memory cell write characteristics and better access times in the conventional semiconductor memory device.

### SUMMARY OF THE INVENTION

Accordingly, an object of the present invention is to provide a semiconductor memory device that has good memory cell write characteristics and offset transistors with desired threshold voltages.

Another object of the present invention is to provide a manufacturing method that can stably manufacture such a semiconductor memory device.

According to the present invention, there is provided a semiconductor memory device comprising: a semiconductor substrate of a first conductivity type; a source and a drain of a second conductivity type, the source and the drain being provided separately in the surface of the semiconductor substrate; a channel between the source and the drain; a first impurity region of the first conductivity type, the first impurity region having an impurity concentration greater than that of the semiconductor substrate, and being provided in the drain side of the channel; a second impurity region of the first conductivity type, the second impurity region having an impurity concentration greater than that of the semiconductor substrate but less than that of the first impurity region, and being provided in the source side of the channel; a floating gate provided on top of the first impurity region, with an isolation film thereunder; and a control gate provided on top of the floating gate and the first impurity region, with an isolation film thereunder.

In the semiconductor memory device of the present invention, since the first impurity region with a concentration of an impurity of the first conductivity type that is higher than that of the semiconductor substrate is provided in the surface of an offset portion (F) of the channel between the drain and source, the threshold voltage of the offset transistor can be set to any desired value.

In addition, since the second impurity region with a concentration of an impurity of the first conductivity type that is greater than that of the first impurity region is provided in the channel under the floating gate, the number of electrons implanted into the floating gate can be increased, improving the memory cell's write characteristics.

According to the present invention there is also provided a method of manufacturing a semiconductor memory device comprising the steps of forming a first impurity region in a specific region of the surface of a semiconductor substrate of a first conductivity type, the first impurity region having an impurity concentration greater than that of the semiconductor substrate; forming a floating gate corresponding to a high-impurity-concentration region above an isolation film formed over the semiconductor substrate of the first conductivity type; forming a second impurity region of the first conductivity type adjacent to the first impurity region, the second impurity region having an impurity concentration greater than that of the semiconductor substrate but less than that of the first impurity region, and being formed by ion implantation using as a mask the floating gate and a layer of resist patterned so as to define a channel width; forming a drain region in the first impurity region, on the side thereof opposite to the second impurity region, the drain region being a high-impurity-concentration region of a second conductivity type opposite to the first conductivity type; forming an oxide film surrounding the floating gate; forming a control gate over the drain region, the floating gate, and the second impurity region; and forming a source region adjacent to the second impurity region, the source region being a high-impurity-concentration region of the second conductivity type, and being formed by ion implantation using as a mask the control gate.

The above method is capable of providing in a simple manner the semiconductor memory device of the present invention.

### BRIEF DESCRIPTION OF THE DRAWINGS

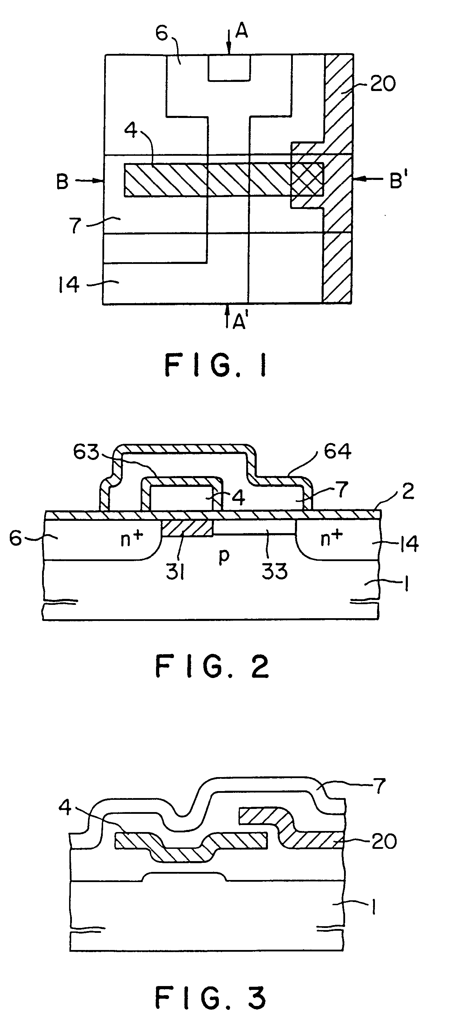

In the accompanying drawings, Fig. 1 is a plan view of the structure of a first embodiment of the semiconductor memory device according to the present invention;
Fig. 2 is a cross-sectional view taken along the line A-A′ of Fig. 1;
Fig. 3 is a cross-sectional view taken along the line B-B′ of Fig. 1;
Figs. 4A to 4D are process diagrams of the method of manufacturing the first embodiment;
Fig. 5 is a cross-sectional view through a second embodiment of the present invention;
Figs. 6A to 6D are process diagrams of the method of manufacturing the second embodiment;
Figs. 7A to 7E are process diagrams of the method of manufacturing a third embodiment of the present invention;
Fig. 8 is a cross-sectional view through a fourth embodiment of the present invention;
Fig. 9 is a cross-sectional view through a fifth embodiment of the present invention; and
Fig. 10 is a graph of impurity density against depth from the surface of a channel on the source side of a semiconductor memory device according to the third embodiment.

### DESCRIPTION OF THE PREFERRED EMBODIMENTS

Figure 1 is a plan view of an example of a memory cell of a flash EEPROM (batch-erasable non-volatile memory) of a first embodiment of the present invention, and Figs. 2 and 3 are cross sectional views of the memory cell taken respectively along the lines A-A′ and B-B′ of Fig. 1.

As shown in Fig. 2, an n-type drain 6 and an n-type source 14 are formed separately on the surface of a p-type semiconductor substrate 1 on which an oxide film (SiO₂) 2 has been formed as an insulation film. A floating gate 4 of polysilicon is formed on top of the oxide film 2 on a channel between the drain 6 and the source 14, in such a manner that it is disposed above the drain 6. A control gate 7 of polysilicon is formed over the floating gate 4 with an oxide film of (of SiO₂) 63 therebetween and a channel between the floating gate 4 and the source 14 with the oxide film of (of SiO₂) 2 therebetween. An oxide film (of SiO₂) 64 is then formed over the control gate 7. A first impurity region 31 of an impurity concentration much greater than that of the semiconductor substrate 1 is provided below the floating gate 4, in contact with the drain 6, and a second impurity region 33 of an impurity concentration greater than that of the semiconductor substrate 1 but less than that of the first impurity region 31 is formed in the channel.

To give one example of the impurity concentrations of the above structure: the impurity concentration of the semiconductor substrate 1 is approximately 2 × 10¹⁵ cm⁻³, that of the drain 6 is 10²⁰ cm⁻³ (at a position close to the surface), that of the source 14 is 10²⁰ cm⁻³ (at a position close to the surface), that of the first impurity region 31 is 1 × 10¹⁷ cm⁻³ (at a position close to the surface), and that of the second impurity region 33 is 4 × 10¹⁶ cm⁻³ (at a position close to the surface).

As can be clearly seen in Figs. 1 and 3, an erase gate 20 that erases electrons implanted into the floating gate 4 is formed on this memory structure.

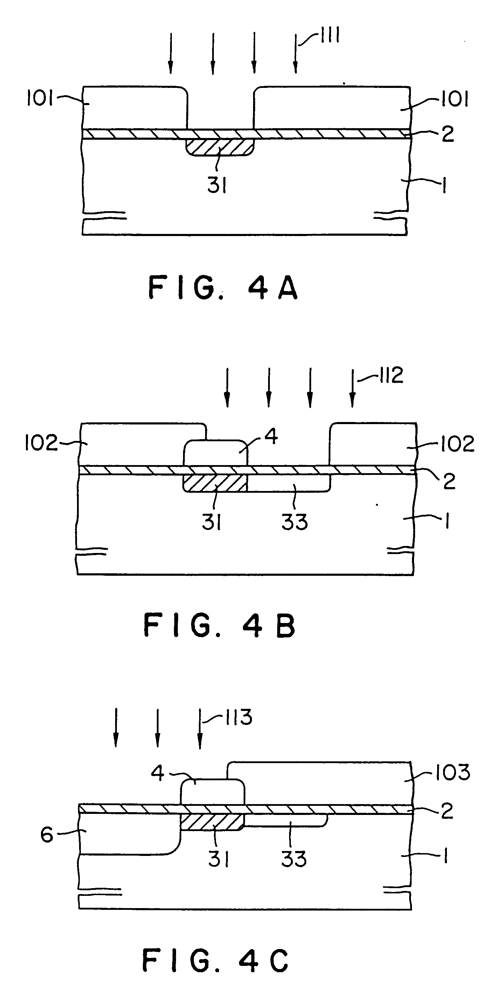

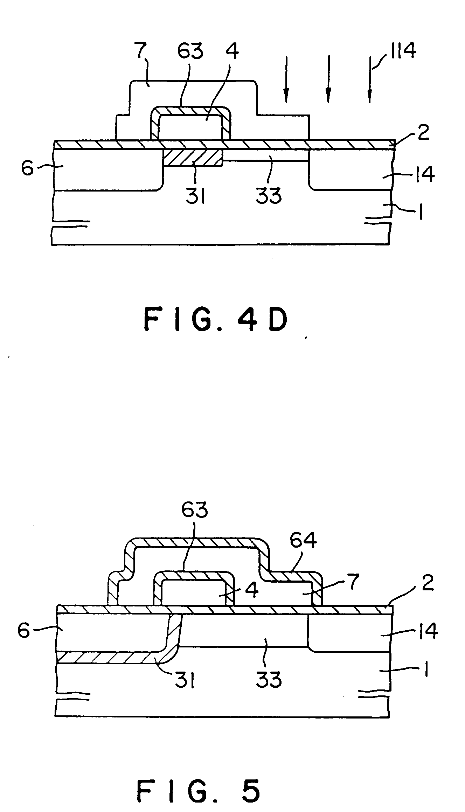

The method of manufacturing the semiconductor memory device of this embodiment will now be described with reference to Figs. 4A to 4D. As shown in Fig. 4A, a layer of resist is deposited on the oxide film 2 over the semiconductor substrate 1, using a spin coating method, and it is exposed to exposure light to form a patterned resist film 101. The resist film 101 is then used as a mask boron ions 111 are implanted into the semiconductor substrate 1 to form the first impurity region 31. After the resist film 101 is removed, the floating gate 4 made of polysilicon is selectively formed over the first impurity region 31, as shown in Fig. 4B. A resist film 102 is then deposited by spin coating and is patterned by exposure to light. The floating gate 4 and the resist film 102 are used as a mask for the implantation of boron ions 112 into the semiconductor substrate 1 to form the second impurity region 33 adjacent to the first impurity region 31. The dose at which the boron ions are implanted is less than that used during the implantation of the first impurity region 31, so the first impurity region 31 has a higher concentration of the boron impurity than the second impurity region 33. After the resist film 102 is removed, a resist film 103 is deposited by spin coating and is patterned by exposure to light, and the floating gate 4 and the resist film 103 are used as a mask for the implantation of arsenic ions 113 to form the drain 6, as shown in Fig. 4C. The arsenic ions are implanted at a dose of 5 × 10¹⁵ cm⁻² with an accelerating energy of 50 keV. After the resist film 103 is removed, the oxide film 63 having a thickness of e.g. 500 Å (10 Å = 1 nm) is formed above the floating gate 4, using a method such as thermal oxidation, for example oxidation in an atmosphere of dry oxygen at approx. 1000°C, as shown in Fig. 4D. The control gate 7 is then formed over the floating gate 4 and the first impurity region 31, with the oxide films 63 and 2 thereunder. Arsenic ions 114 are implanted into the entire surface at a dose of 5 × 10¹⁵ cm⁻² with energy of 50 keV, using the control gate 7 as a mask, to form the source 14. Finally, the oxide film 64 is formed over the control gate 7 by a method such as thermal oxidation, to obtain the semiconductor memory device of the embodiment of the present invention shown in Fig. 2.

In this embodiment, since the first impurity region 31 with its high concentration of p-type impurity is adjacent to the n-type drain 6, the electric field can easily focus. Since this increases the generation probability of electrons injected into the floating gate 4, the memory cell write characteristics are improved. In addition, since the second impurity region 33 with its required impurity concentration that is lower than that of the first impurity region 31 is provided in the channel below the control gate 7, the threshold voltage Vₜₕ of the memory cell's transistor can be set to any desired value. Therefore, current flows easily in the memory cell, and thus access times can be increased.

A second embodiment of the present invention will now be described with reference to Fig. 5.

In this embodiment, the drain 6 and source 14 are formed separately on the surface of the p-type semiconductor substrate 1 on which the oxide film 2 that acts as an insulation film has been formed, and the first impurity region 31 is formed so as to surround the drain 6, of a p-type impurity of a higher concentration than that of the semiconductor substrate 1. The p-type second impurity region 33 is formed with an impurity concentration that is higher than that of the semiconductor substrate 1, but lower than that of the first impurity region 31, between the first impurity region 31 and the source 14. The floating gate 4 is formed above the channel, in such a way that it is in contact with the drain 6, with the oxide film 2 therebetween. The control gate 7 is formed above the floating gate 4 (with the oxide film 63 therebetween) and an offset portion (F) (with the oxide film 2 therebetween), then the oxide film 64 is formed over the surface of the floating gate 4.

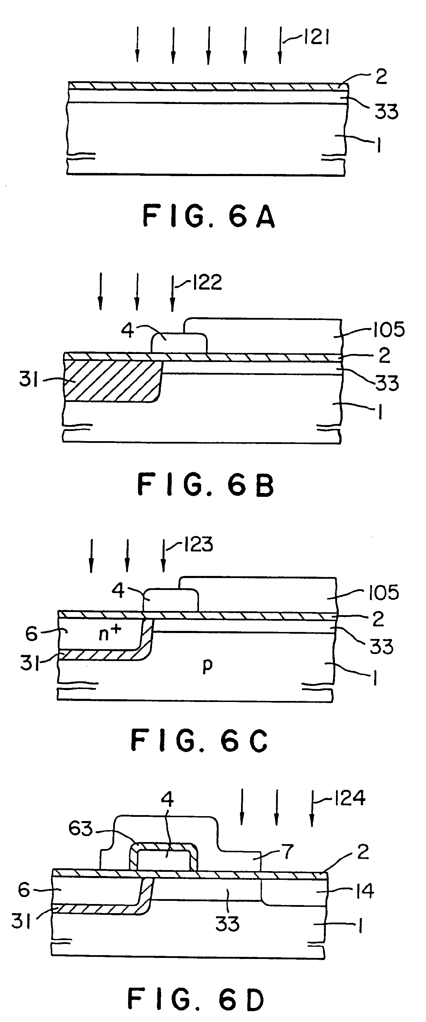

The method of manufacturing the semiconductor memory device of the second embodiment will now be described with reference to Figs. 6A to 6D. As shown in Fig. 6A, boron ions 121 are implanted by an ion implantation method at a dose of 4 × 10¹² cm⁻² with energy of 60 keV into the surface of the p-type semiconductor substrate 1 on which the oxide film 2 has been formed, to form the second impurity region 33 that has a higher impurity concentration than that of the semiconductor substrate 1. Next, as shown in Fig. 6B, the floating gate 4 is formed at a desired position on the semiconductor substrate 1 by depositing a polysilicon film thereon by a CVD method then patterning it. A layer of resist is deposited and patterned to form a resist film 105. The resist film 105 and the floating gate 4 are used as a mask for the implantation of boron ions 122 to form the first impurity region 31. The boron ions 122 are implanted at a dose of 2 × 10¹³ cm⁻² with an accelerating voltage of 100 keV that is higher than that used during the ion implantation that formed the second impurity region 33, and, after the ion implantation, a thermal process (annealing at approx. 1000°C in inert gas (N₂) atmosphere for 20 minutes) is employed to diffuse the first impurity region 31 into the semiconductor substrate 1. Next, the resist film 105 and the floating gate 4 are again used as a mask for the implantation of arsenic ions 123 at a dose of 5 × 10¹⁵ cm⁻² using an acceleration energy of 50 keV to form the drain 6 in a self-aligning manner, as shown in Fig. 6C. After the resist film 105 is removed, the oxide (SiO₂) film 63 having a thickness of 500 Å is formed above the floating gate 4 by a thermal oxidation method, and the control gate 7 is formed above the floating gate 4 (with the oxide film 63 therebetween) and an offset portion (F) (with the oxide film 2 therebetween). The control gate 7 is then used as a mask for the implantation of arsenic ions 124 at a dose of 5 × 10¹⁵ cm⁻² with energy of 50 keV to form the source 14. Finally, the oxide film 64 is formed over the control gate 7 by a thermal oxidation method, to obtain the semiconductor memory device of the second embodiment.

In the structure of the semiconductor memory device of this embodiment, the mask used for the formation of the first impurity region 31 can readily be used for the formation of the drain 6. Since the drain 6 and the first impurity region 31 are adjacent to each other, the electric field can easily focus. This increases the generation probability of electrons, accelerating the electrons injected in the floating gate 4 and improving the memory cell write characteristics. In addition, the impurity concentration of the second impurity region 33, which is higher than that of the semiconductor substrate 1, can be adjusted to a required concentration such that the threshold voltage Vₜₕ of the memory cell transistor can be set to any desired value. Therefore, current flows easily in the memory cell, and thus access times can be increased.

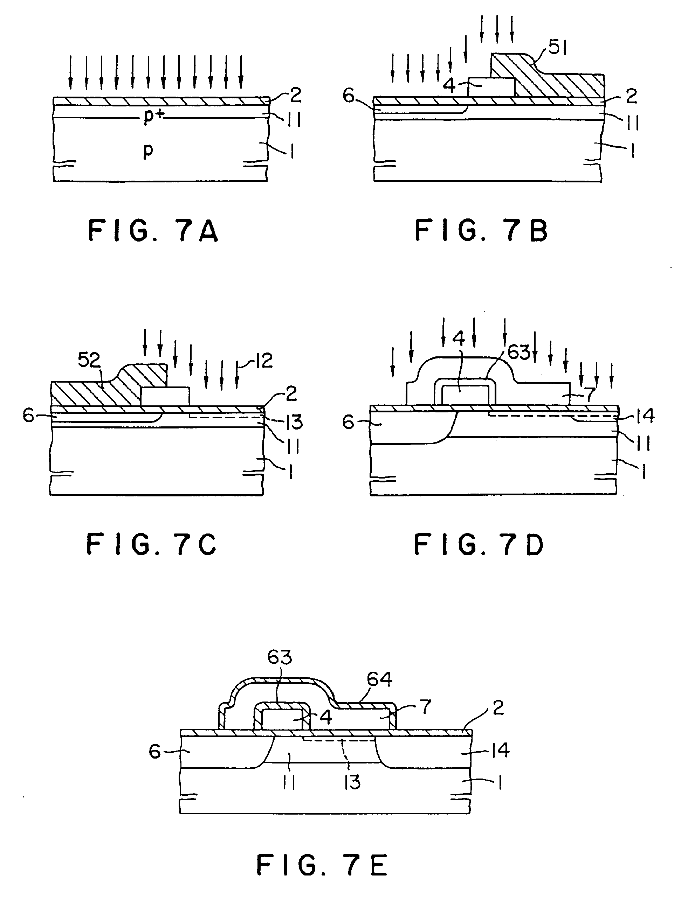

The method of manufacturing the semiconductor memory device of a third embodiment of the present invention will now be described with reference to Figs. 7A to 7E. As shown in Fig. 7A, after a silicon oxide film 2 is formed as an insulation film over the semiconductor substrate 1 made of p-type polysilicon, ions are implanted into the entire surface to form a high-impurity-concentration region 11. The implantation could be, for example, of boron ions using an accelerating energy of about 60 keV. The conventional dose for such implantation is 3 × 10¹² cm⁻², but in this embodiment it is increased to a higher dose of 6 × 10¹² cm⁻². Polysilicon is deposited on the oxide film 2 and is patterned to form the floating gate 4 in a desired position, then photoresist 51 is selectively left in the position shown in Fig. 7B. The floating gate 4 and the photoresist 51 are used as a mask for the implantation of arsenic ions with energy of 50 keV, for example, to form the drain 6 in a self-aligning manner. Subsequently, the dose is set to 5 × 10¹⁵ cm⁻². After the photoresist 51 is removed, more photoresist 52 is selectively left over the drain 6, and this photoresist 52 and the floating gate 4 are used as a mask for the shallow implantation of arsenic ions into the surface of the semiconductor substrate 1, to form a shallow region 13 (Fig. 7C). In this case, the accelerating energy is about 80 to 170 keV, and the dose is 1 to 3 × 10¹² cm⁻². After the photoresist 52 is removed, the oxide film 63 having a thickness of 400 Å is formed on the floating gate 4 by a method such as thermal oxidation for example, heating at 1000°C in dry oxygen atmosphere, and the control gate 7 is formed of polysilicon over the oxide film 63. The source 14 is then formed by the implantation of ions at a dose of 5 × 10¹⁵ cm⁻² with energy of 50 keV, for example arsenic ions, into the entire surface, using the control gate 7 as a mask (Fig. 7D). Next, the oxide film 64 is formed by thermal oxidation over the control gate 7. At the same time, the source 14 is diffused by a method such as thermal oxidation for example, annealing at 1000°C in dry oxygen atmosphere for 10 minutes, to obtain the semiconductor memory device of the third embodiment.

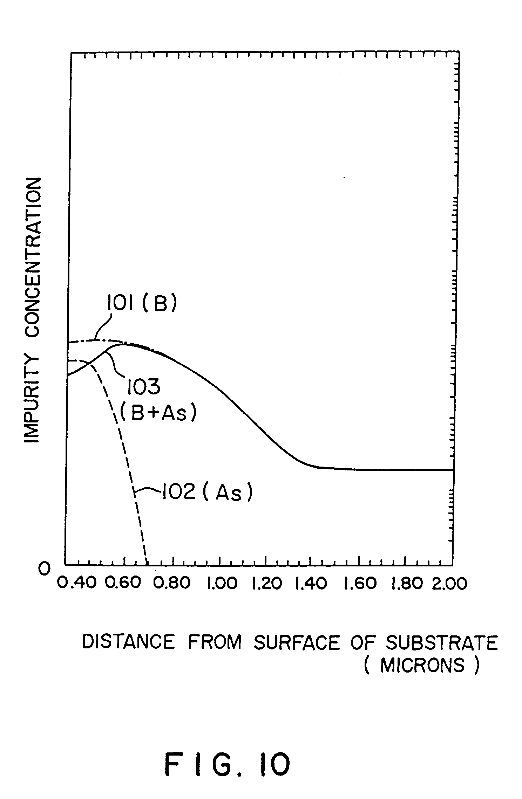

Results of measuring impurity concentration with respect to distance from the surface of the substrate of the semiconductor memory device of the third embodiment are shown in Fig. 10. Curve 101 shows the concentration of the p-type impurity boron, curve 102 shows the concentration of the n-type impurity arsenic, and curve 103 shows the concentration of a p-type impurity which is a combination of boron and arsenic. It is clear from curve 103 that the concentration of p-type impurity near the surface of the semiconductor substrate 1 is controlled and reduced by arsenic. As described above, since the semiconductor memory device of Fig. 7E is provided with a shallow region 13 that has a desired concentration of p-type impurity that is less than that of the source 14, the threshold voltage Vₜₕ of the offset transistor can be set to any desired value, facilitating current flow in the memory cell and improving access times. In addition, since the n-type drain 6 and the p-type high-impurity-concentration region 11 are in contact with each other, the generation probability of electrons implanted into the floating gate 4 is increased and the memory cell write characteristics are improved. Further, since this semiconductor memory device according to the third embodiment of the present invention can be manufactured to a higher precision than those of the first and second embodiments, it can provide an even smaller semiconductor memory device.

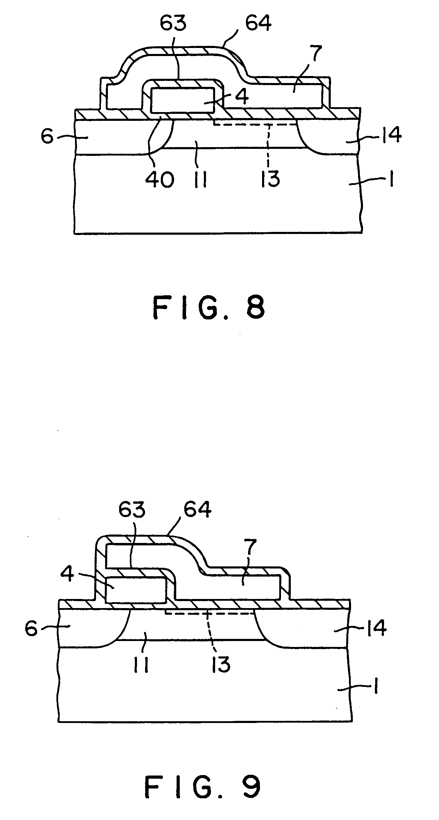

Other embodiments of the present invention can be conceived, such as a fourth embodiment of the present invention, shown in Fig. 8, which is the same as the third embodiment except that a portion of the isolation film 40 under the floating gate 4 and the drain 6 is formed to be thinner than the rest of the isolation film, which improves the memory cell write characteristics, and a fifth embodiment of the present invention, shown in Fig. 9, which is the same as the third embodiment except that the control gate 7 and the floating gate 4 are formed in a self-aligning manner on the drain 6 side. These and other embodiments of the present invention provide a semiconductor memory device having good memory cell write characteristics and offset transistors with desired threshold voltages Vₜₕ.

## Claims

1. A semiconductor memory device comprising:
a semiconductor substrate (1) of a first conductivity type;
a source (14) and a drain (6) of a second conductivity type, said source and said drain being provided separately in the surface of said semiconductor substrate;
a channel between said source and said drain;
a first impurity region (11,31) of said first conductivity type, said first impurity region having an impurity concentration greater than that of said semiconductor substrate, and being provided in the drain side of said channel;
a second impurity region (13,33) of said first conductivity type, said second impurity region having an impurity concentration greater than that of said semiconductor substrate but less than that of said first impurity region, and being provided in the source side of said channel;
a floating gate (4) provided on top of said first impurity region, with an isolation film (2) thereunder; and
a control gate (7)provided on top of said floating gate and said first impurity region, with an isolation film (63) thereunder.

2. The semiconductor memory device according to claim 1, wherein said first impurity region (31) is provided surrounding said drain.

3. The semiconductor memory device according to claim 1, wherein said second impurity region (13) is provided on the source side of the surface of said first impurity region.

4. The semiconductor memory device according to claim 1, wherein the thickness of said isolation film under said floating gate is less than the thickness of other portions thereof.

5. The semiconductor memory device according to claim 1, wherein an end surface of said control gate on said drain side is formed to be self-aligning with respect to an end surface of said floating gate.

6. A method of manufacturing a semiconductor memory device according to claims 1,4 or 5 comprising the steps of:
forming a first impurity region (31) in a specific region of the surface of a semiconductor substrate (1) of a first conductivity type, said first impurity region having an impurity concentration greater than that of said semiconductor substrate;
forming a floating gate (4) corresponding to said first impurity region above an isolation film (2) formed over said semiconductor substrate of said first conductivity type;
forming a second impurity region (33) of said first conductivity type adjacent to said first impurity region, said second impurity region having an impurity concentration greater than that of said semiconductor substrate but less than that of said first impurity region, and being formed by ion implantation using as a mask said floating gate and a layer of resist (102) patterned so as to define a channel width;
forming a drain region (6) in said first impurity region, on the side thereof opposite to said second impurity region, said drain region being a high-impurity-concentration region of a second conductivity type opposite to said first conductivity type;
forming an oxide film (63) surrounding said floating gate;
forming a control gate (7) over said drain region, said floating gate, and said second impurity region; and
forming a source region (14) adjacent to said second impurity region, said source region being a high-impurity-concentration region of said second conductivity type, and being formed by ion implantation using as a mask said control gate.

7. The method of manufacturing a semiconductor memory device according to claim 6, wherein said oxide film surrounding said floating gate is formed by a thermal oxidation method.

8. A method of manufacturing a semiconductor memory device according to claims 1,2,4 or 5 comprising the steps of:
forming a second impurity layer (33) by ion implantation into a semiconductor substrate (1) of a first conductivity type and having an insulation film (2) on the surface thereof, said second impurity layer having an impurity concentration greater than that of said semiconductor substrate;
forming a floating gate (4) on said isolation film at a specific position thereon;
forming a first impurity layer (31) of said first conductivity type, said first impurity layer having an even greater impurity concentration than said second impurity layer and being deeper than said second impurity layer, and being formed by ion implantation using as a mask a layer of resist (105) selectively formed over said floating gate and a region destined to become a channel;
forming an oxide film (63) surrounding said floating gate;
forming a drain region (6) in said first impurity region, said drain region being a high-impurity-concentration diffusion region formed in a self-aligning manner of an impurity of a second conductivity type opposite to said first conductivity type, and being formed by ion implantation using as a mask said floating gate and said resist;
forming a control gate (7) above said insulation film and said floating gate, said control gate being of a length such as to determine the width of said channel; and
forming a source region (14), said source region being a high-impurity-concentration diffusion region formed in a self-aligning manner of an impurity of said second conductivity type, and being formed by ion implantation using as a mask said control gate.

9. A method of manufacturing a semiconductor memory device according to claims 1,3,4 or 5 comprising the steps of
forming a first impurity layer (11) by ion implantation into a semiconductor substrate (1) of a first conductivity type and having an insulation film (2) on the surface thereof, said first impurity layer having an impurity concentration greater than that of said semiconductor substrate;
forming a floating gate (4) on said isolation film at a specific position thereon;
forming a high-concentration layer (6) of a second conductivity type opposite to said first conductivity type, within said first impurity layer, said high-concentration layer being formed by ion implantation using as a mask a layer of resist (51) selectively formed over said floating gate and a region destined to become a channel;
forming a second impurity layer (13) of said first impurity type, said second impurity layer having a concentration less than that of said first impurity layer, and being formed in a self-aligning manner with respect to said floating gate in a region destined to be a channel region by shallow implantation of ions of said second conductivity type, using as a mask said floating gate and a layer of resist (52) formed on said first impurity region;
forming by oxidation an oxide film (63) surrounding said floating gate and forming by dispersing said high-concentration region (6) a drain region having a dispersion depth deeper than that of said first impurity layer;
selectively forming a control gate (7) above said drain region, said floating gate, and said channel region; and
forming a source region (14) in a self-aligning manner with respect to said control gate, said source region being formed by implantation and dispersion of ions of said second conductivity type within said second impurity layer, using as a mask said control gate.

## Patentansprüche

1. Halbleiterspeichervorrichtung mit:
einem Halbleitersubstrat (1) eines ersten Leitungstyps;
einer Source (14) und einem Drain (6) eines zweiten Leitungstyps, wobei die Source und der Drain separat vorgesehen sind in der Oberfläche des Halbleitersubstrats;
einem Kanal zwischen der Source und dem Drain;
einem ersten Verunreinigungsbereich (11, 31) des ersten Leitungstyps, wobei der erste Verunreinigungsbereich eine größere Verunreinigungskonzentration hat als die des Halbleitersubstrats und auf der Drainseite des Kanals vorgesehen ist;
einem zweiten Verunreinigungsbereich (13, 33) des ersten Leitungstyps, wobei der zweite Verunreinigungsbereich eine höhere Verunreinigungskonzentration hat als die des Halbleitersubstrats, aber eine geringere als die des ersten Verunreinigungsbereichs und auf der Sourceseite des Kanals vorgesehen ist;
einem erdfreien Gate (4), das vorgesehen ist auf dem ersten Verunreinigungsbereich, wobei ein Isolationsfilm (2) darunter ist; und
einem Steuergate (7), das vorgesehen ist auf dem erdfreien Gate und dem ersten Verunreinigungsbereich, wobei ein Isolationsfilm (63) darunter ist.

2. Halbleiterspeichervorrichtung nach Anspruch 1, dadurch gekennzeichnet, daß der erste Verunreinigungsbereich (31) den Drain umgebend vorgesehen ist.

3. Halbleiterspeichervorrichtung nach Anspruch 1, dadurch gekennzeichnet, daß der zweite Verunreinigungsbereich (13) auf der Sourceseite der Oberfläche des ersten Verunreinigungsbereiches vorgesehen ist.

4. Halbleiterspeichervorrichtung nach Anspruch 1, dadurch gekennzeichnet, daß die Dicke des Isolationsfilms unter dem erdfreien Gate geringer als die Dicke der anderen Abschnitte davon ist.

5. Halbleiterspeichervorrichtung nach Anspruch 1, dadurch gekennzeichnet, daß eine Endoberfläche des Steuergates auf der Drainseite selbstausrichtend gebildet ist mit Bezug auf eine Endoberfläche des erdfreien Gates.

6. Verfahren zum Herstellen einer Halbleiterspeichervorrichtung nach Anspruch 1, 4 oder 5 mit den Schritten:
Bilden eines ersten Verunreinigungsbereiches (31) in einem speziellen Bereich der Oberfläche eines Halbleitersubstrats (1) eines ersten Leitungstyps, wobei der erste Verunreinigungsbereich eine größere Verunreinigungskonzentration als das Halbleitersubstrat hat;
Bilden eines erdfreien Gates (4) entsprechend dem ersten Verunreinigungsbereich eines Isolationsfilms (2), gebildet oberhalb des Halbleitersubstrats des ersten Leitungstyps;
Bilden eines zweiten Verunreinigungsbereichs (33) des ersten Leitungstyps neben dem ersten Verunreinigungsbereich, wobei der zweite Verunreinigungsbereich eine höhere Verunreinigungskonzentration als das Halbleitersubstrat, aber eine niedrigere als der erste Verunreinigungsbereich hat und gebildet wird durch Ionenimplantation unter Benutzung des erdfreien Gates und einer strukturierten Photolackschicht (102) zum Definieren einer Kanalbreite;
Bilden eines Drainbereichs (6) in dem ersten Verunreinigungsbereich auf der Seite davon, welche dem zweiten Verunreinigungsbereich gegenüberliegt, wobei der Drainbereich ein Bereich mit hoher Verunreinigungskonzentration eines zweiten Leitungstyps ist, welcher dem ersten Leitungstyp entgegengesetzt ist;
Bilden eines Oxydfilms (63), umgebend das erdfreie Gate;
Bilden eines Steuergate (7) über dem Drainbereich, dem erdfreien Gate und dem zweiten Verunreinigungsbereich; und
Bilden eines Sourcebereichs (14) neben dem zweiten Verunreinigungsbereich, wobei der Sourcebereich ein Bereich mit hoher Verunreinigungskonzentration des zweiten Leitungstyps ist und gebildet wird durch Ionenimplantation unter Benutzung des Steuergates als Maske.

7. Verfahren zum Herstellen einer Halbleiterspeichervorrichtung nach Anspruch 6, dadurch gekennzeichnet, daß der Oxydfilm, der das erdfreie Gate umgibt, durch ein thermisches Oxidationsverfahren gebildet wird.

8. Verfahren zum Herstellen einer Halbleiterspeichervorrichtung nach Anspruch 1, 2, 4 oder 5 mit den Schritten:
Bilden einer zweiten Verunreinigungsschicht (33) durch Ionenimplantation in ein Halbleitersubstrat (1) eines ersten Leitungstyps und mit einem Isolationsfilm (2) auf der Oberfläche davon, wobei die zweite Verunreinigungsschicht eine Verunreinigungskonzentration, welche größer ist als die des Halbleitersubstrats, hat;
Bilden eines erdfreien Gates (4) auf dem Isolationsfilm an einer speziellen Position darauf;
Bilden einer ersten Verunreinigungsschicht (31) des ersten-Leitungstyps, wobei die erste Verunreinigungsschicht eine noch größere Verunreinigungskonzentration hat als die zweite Verunreinigungsschicht und tiefer liegt als die zweite Verunreinigungsschicht und gebildet wird durch eine Ionenimplantation unter Benutzung einer Schicht von Photolack (105), selektiv gebildet oberhalb des erdfreien Gates und in einem Bereich, der dazu bestimmt ist, ein Kanal zu werden;
Bilden eines Oxydfilms (63), umgebend das erdfreie Gate;
Bilden eines Drainbereichs (6) in dem ersten Verunreinigungsbereich, wobei der Drainbereich ein Diffusionsbereich mit einer hohen Verunreinigungskonzentration ist, der auf eine selbstausrichtende Art und Weise aus einer Verunreinigung eines zweiten Leitungstyps, welcher dem ersten Leitungstyp entgegengesetzt ist, gebildet wird und gebildet wird durch Ionenimplantation unter Benutzung des erdfreien Gates und des Photolacks als Maske;
Bilden eines Steuergates (7) oberhalb des Isolationsfilms und des erdfreien Gates, wobei das Steuergate von solch einer Länge ist, daß es die Breite des Kanals bestimmt; und
Bilden eines Sourcebereichs (14), wobei der Sourcebereich ein Diffusionsbereich mit hoher Verunreinigungskonzentration ist, welcher auf selbstausrichtende Art und Weise aus einer Verunreinigung des zweiten Leitungstyps gebildet wird und gebildet wird durch eine Ionenimplantation unter Benutzung des Steuergates als Maske.

9. Verfahren zum Herstellen einer Halbleiterspeichervorrichtung nach Anspruch 1, 3, 4 oder 5 mit den Schritten:
Bilden einer ersten Verunreinigungsschicht (11) durch Ionenimplantation in ein Halbleitersubstrat (1) eines ersten Leitungstyps und mit einem Isolatonsfilm (2) auf der Oberfläche davon, wobei die erste Verunreinigungsschicht eine Verunreinigungskonzentration hat, die größer ist als die des Halbleitersubstrats;
Bilden eines erdfreien Gates (4) auf dem Isolationsfilm an einer speziellen Position darauf;
Bilden einer Schicht (6) mit hoher Konzentration eines zweiten Leitungstyps, welcher den ersten Leitungstyp entgegengesetzt ist, innerhalb der ersten Verunreinigungsschicht, wobei die Schicht mit hoher Konzentraion gebildet wird durch eine Ionenimplantation unter Benutzung einer Photolackschicht (51), selektiv gebildet über dem erdfreien Gate und in einem Bereich, der dazu bestimmt ist, ein Kanal zu werden;
Bilden einer zweiten Verunreinigungsschicht (13) des ersten Verunreinigungstyps, wobei die zweite Verunreinigungsschicht eine Konzentration hat, die kleiner ist als die der ersten Verunreinigungsschicht und auf eine selbstausrichtende Art und Weise gebildet wird bezüglich des erdfreien Gates in einem Bereich, der bestimmt ist ein Kanalbereich zu werden, durch flache Implantation von Ionen des zweiten Leitungstyps unter Benutzung des erdfreien Gates und einer Photolackschicht (52), gebildet auf dem ersten Verunreinigungsbereich, als Maske;
Bilden eines Oxydfilms (63) durch Oxidation, umgebend das erdfreie Gate, und Bilden eines Drains durch Zerstreuen des Bereiches mit hoher Konzentration mit einer Zerstreuungstiefe, welche tiefer ist als die des ersten Verunreinigungsbereichs;
selektives Bilden eines Steuergates (7) oberhalb des Drainbereichs, des erdfreien Gates und des Kanalbereichs; und
Bilden eines Sourcebereichs (14) in einer selbstausrichtenden Art und Weise bezüglich des Steuergates, wobei der Sourcebereich gebildet wird durch Implantation und Zerstreuung der Ionen des zweiten Leitungstyps innerhalb der zweiten Verunreinigungsschicht unter Benutzung des Steuergates als Maske.

## Revendications

1. Un dispositif de mémoire à semi-conducteur comprenant
un substrat semi-conducteur (1) d'un premier type de conductivité;
une source (14) et un drain (6) d'un deuxième type de conductivité, ladite source et ledit drain étant réalisés séparément dans la surface dudit substrat semi-conducteur;
un canal entre ladite source et ledit drain;
une première région d'impuretés (11, 31) dudit premier type de conductivité, la concentration d'impuretés dans ladite première région d'impuretés étant supérieure à celle dudit substrat semiconducteur et la région étant réalisée dans le côté drain dudit canal;
une deuxième région d'impuretés (13, 33) dudit premier type de conductivité, la concentration d'impuretés de ladite deuxième région d'impuretés étant supérieure à celle dudit substrat semiconducteur mais étant inférieure à celle de ladite première région d'impuretés et la région étant réalisée dans le côté source dudit canal;
Une grille flottante (4) réalisée au-dessus de ladite première région d'impuretés, un film d'isolement (2) lui étant sous-jacent; et
une grille de commande (7) réalisée au-dessus de ladite grille flottante et de ladite première région d'impuretés, un film d'isolement (63) lui étant sous-jacent.

2. Le dispositif de mémoire à semi-conducteur selon la revendication 1, dans lequel ladite première région d'impuretés est réalisée de manière à entourer ledit drain.

3. Le dispositif de mémoire à semi-conducteur selon la revendication 1, dans lequel ladite deuxième région d'impuretés (13) est réalisée sur le côté source de la surface de ladite première région d'impuretés.

4. dispositif de mémoire à semi-conducteur selon la revendication 1, dans lequel l'épaisseur dudit film d'isolement sous-jacent à ladite grille flottante est inférieure à l'épaisseur des autres parties de ce film.

5. Le dispositif de mémoire à semi-conducteur selon la revendication 1, dans lequel une surface d'extrémité de ladite grille de commande sur ledit côte de drain est formée de façon à s'aligner automatiquement par rapport à une face d'extrémité de ladite grille flottante.

6. Un procédé de fabrication d'un dispositif de mémoire à semi-conducteur selon l'une des revendications 1, 4 ou 5 comprenant les étapes consistant à:
former une première région d'impuretés (31) dans une région spécifique de la surface de substrat à semi-conducteur (1) d'un premier type de conductivité, la concentration d'impuretés de ladite première région d'impuretés étant supérieure à celle dudit substrat semi-conducteur;
former une grille flottante (4) correspondant a ladite première région d'impuretés au-dessus d'un film d'isolement (2) formé au-dessus dudit substrat semiconducteur dudit premier type de conductivité;
former une deuxième région d'impuretés (33) dudit premier type de conductivité près de ladite première région d'impuretés, la concentration d'impuretés de ladite deuxième région étant supérieure à celle dudit substrat semi-conducteur mais inférieure à celle de ladite première région d'impuretés et la région étant formée par implantation ionique en utilisant comme masque ladite grille flottante et une couche de résine photosensible (102) configurée de façon à définir une largeur de canal;
former dans ladite première région d'impuretés une région de drain (6) sur le côté de celle-ci opposé à ladite deuxième région d'impuretés, ladite région de drain étant une région à haute concentration d'impuretés d'un deuxième type de conductivité opposé audit premier type de conductivité;
former un film d'oxyde (63) entourant ladite grille flottante;
former une grille de commande (7) au-dessus de ladite région de drain, de ladite grille flottante et de ladite deuxième région d'impuretés; et
former une région de source (19) près de ladite deuxième région d'impuretés, ladite région de source étant une région à haute concentration d'impuretés dudit deuxième type de conductivité et étant formée par implantation ionique en utilisant comme masque ladite grille de commande.

7. Le procédé de fabrication d'un dispositif de mémoire à semi-conducteur selon la revendication 6, dans lequel ledit film d'oxyde entourant ladite grille flottante est formé par un procédé d'oxydation thermique.

8. Un procédé de fabrication d'un dispositif de mémoire à semi-conducteur selon l'une des revendications 1, 2, 4 ou 5 comprenant les étapes consistant à:
former par implantation ionique une deuxième couche d'impuretés (33) dans un substrat semiconducteur (1) d'un premier type de conductivité qui porte sur sa surface un film d'isolement (2), la concentration d'impuretés de ladite deuxième couche d'impuretés étant supérieure à celle dudit substrat semi-conducteur;
former une grille flottante (4) sur ledit film d'isolement à une position spécifique sur celui-ci;
former une première couche d'impuretés (31) dudit premier type de conductivité, la concentration en impuretés de ladite première couche d'impuretés étant encore supérieure à celle de ladite deuxième couche d'impuretés et la couche étant plus profonde que celle de ladite deuxième couche d'impuretés, et étant formée par implantation ionique en utilisant comme masque une couche de résine photosensible (105) formée de façon sélective au-dessus de ladite grille flottante et d'une région destinée à devenir un canal;
former un film d'oxyde (63) entourant ladite grille flottante;
former une région de drain (6) dans ladite première région d'impuretés, ladite région de drain étant une région de diffusion à haute concentration d'impuretés formée par auto-alignement d'une impureté d'un deuxième type de conductivité opposé audit premier type de conductivité et étant formée par implantation ionique en utilisant comme masque ladite grille flottante et ladite résine photosensible;
former une grille de commande (7) au-dessus dudit film d'isolement et de ladite grille flottante, ladite grille de commande étant d'une longueur apte à déterminer la largeur dudit canal; et
former une région de source (14), ladite région de source étant une région de diffusion à haute concentration en impuretés formée par auto-alignement d'une impureté dudit deuxième type de conductivité et étant formée par implantation ionique en utilisant comme masque ladite ligne de commande.

9. Un procédé de fabrication d'un dispositif de mémoire à semi-conducteur selon l'une des revendications 1, 3, 4 ou 5, comprenant les étapes consistant à:
former par implantation ionique une première couche d'impuretés (11) dans un substrat semiconducteur (1) d'un premier type de conductivité qui porte sur sa surface un film d'isolement (2), la concentration d'impuretés de ladite première couche d'impuretés étant supérieure à celle dudit substrat semi-conducteur;
former une grille flottante (4) sur ledit film d'isolement à une position spécifique sur celui-ci;
former à l'intérieur de ladite première couche d'impuretés une couche (6) à haute concentration d'un deuxième type de conductivité opposé audit premier type de conductivité, ladite couche à haute concentration étant formée par implantation ionique en utilisant comme masque une couche de résine photosensible (51) formée sélectivement au-dessus de ladite grille flottante et d'une région destinée à devenir un canal;
former une deuxième couche d'impuretés (13) dudit premier type d'impuretés, la concentration de ladite deuxième couche d'impuretés étant inférieure à celle de ladite première couche d'impuretés, et la couche étant formée par auto-alignement par rapport à ladite grille flottante dans une région destinée à être une région de canal par une implantation peu profonde d'ions du deuxième type de conductivité, en utilisant comme masque ladite grille flottante et une couche de résine photosensible (52) formée sur ladite première région d'impuretés;
former par oxydation un film d'oxyde (63) entourant ladite grille flottante et former en dispersant ladite région (6) de haute concentration une région de drain dont la profondeur de dispersion est plus profonde que celle de ladite première couche d'impuretés;
former sélectivement une grille de commande (7) au-dessus de ladite région de drain, de ladite grille flottante, et de ladite région de canal; et
former une région de source (14) par auto-alignement par rapport à ladite grille de commande, ladite région de source étant formée par implantation et dispersion d'ions dudit deuxième type de conductivité à l'intérieur de ladite deuxième couche d'impuretés, en utilisant comme masque ladite grille de commande.
